# EUROPEAN PATENT SPECIFICATION

(11) **EP 0 942 641 B1**
(45) Date of publication and mention of the grant of the patent: **29.01.2003**
(21) Application number: 99301927.2
(22) Date of filing: 12.03.1999
(51) Int. Cl.: H05K 13/04, H05K 13/08

(54) **Electronic component mounting machine and method therefor**
Bestückungsautomat und -verfahren für elektronische Bauteile
Machine de montage de composants électroniques et méthode associée

(30) Priority: 12.03.1998 JP 6110398; 17.02.1999 JP 3805899
(43) Date of publication of application: 15.09.1999
(73) Proprietor: Juki Corporation, Chofu-shi, Tokyo 182-8655 (JP)
(72) Inventor: Taguchi, Katsuhiko, Chofu-shi, Tokao, 182-8655 (JP)
(74) Representative: Lyndon-Stanford, Edward Willoughby Brooke

(56) References cited:
- EP-A- 0 808 091
- WO-A-95/19099
- PATENT ABSTRACTS OF JAPAN vol. 016, no. 271 (E-1218), 18 June 1992 (1992-06-18) & JP 04 064283 A (MATSUSHITA ELECTRIC IND CO LTD), 28 February 1992 (1992-02-28)

## Description

The present invention relates to a machine for mounting electronic components comprising a machine for mounting electronic components comprising a board conveyor section for conveying in a transporting direction circuit boards through a board carry-in area, two board positioning areas and a board carry-out area in this order and stopping them in the board positioning areas, an electronic component storage section disposed along the board conveyor section for supplying the electronic components sequentially, a head unit having a plurality of component pick-up units, each pick-up unit having a pick-up nozzle for receiving one of the components from the component storage section and placing it onto a board positioned at a positioning area, and each pick-up unit (34) including an angular positioning device for the nozzle, and an XY robot for supporting and moving the head unit in an X direction parallel to the transporting direction of the boards and in a Y direction perpendicular thereto, wherein the head unit has two transport units supported slidably on one X-guide, each transport unit being movable independently to the other in the X direction and having at least one component pick-up unit.

The present invention also relates to a method for mounting components in an electronic component mounting machine, comprising the steps of conveying circuit boards through a board carry-in area, two board positioning areas, and a board carry-out area in this order and stopping them in the board positioning areas, picking up components from a component storage section with pick-up nozzles, altering the angular orientation of each picked up component by an angular positioning device of a pick-up unit, positioning two transport units above predetermined X coordinate positions on the boards placed on respective board positioning areas with independent movement in an X direction, positioning by an XY robot, one of the transport units above a predetermined Y coordinate position on the board placed on one of the board positioning areas.

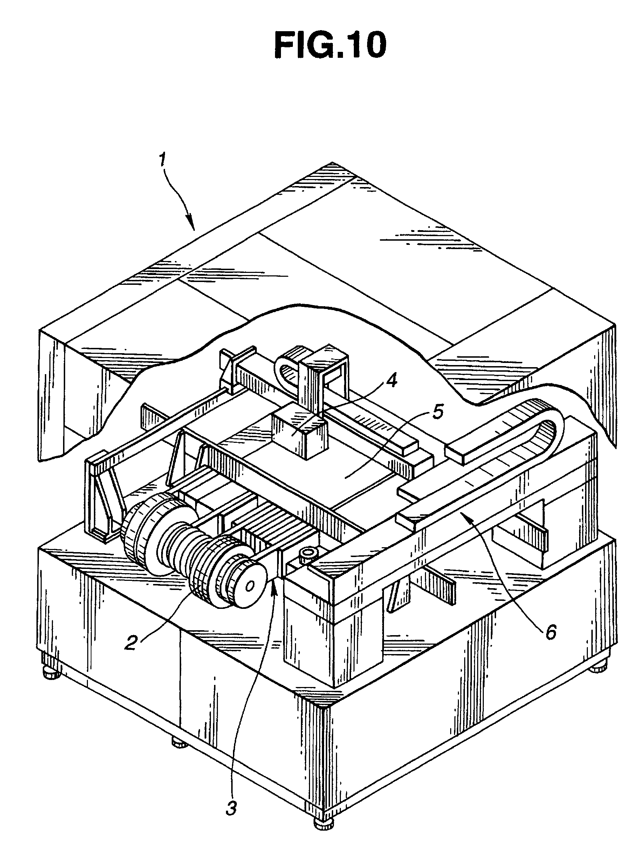

As shown in Fig. 10, in a conventional electronic component mounting machine, an electronic component is fed one by one by means of a component feeder 3 from a reel 2, which has a paper or plastic tape wound around and contains electronic components thereon, picked-up by a head unit 4, and mounted on a circuit board 5.

The head unit 4 is moved in XY directions on a plane parallel to the circuit board 5 by means of an XY robot 6.

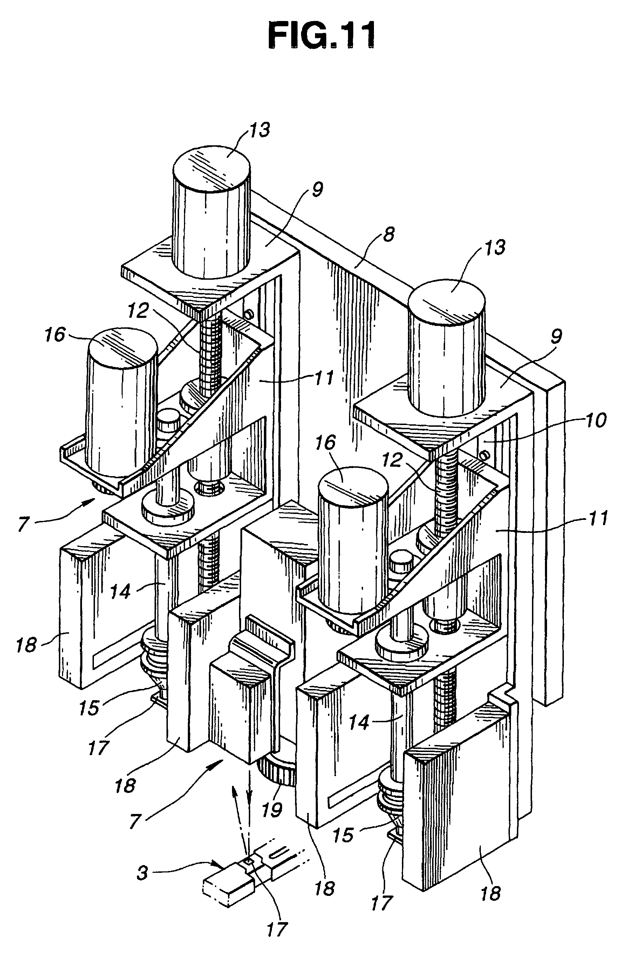

Referring to Fig.11 showing an enlarged perspective view of the head unit, the head unit 4 has generally one or more component pick-up units 7, 7, and is supported on the XY robot 6 via a mechanical interface member 8.

The component pick-up unit 7 has a structural member 9 fixed on the surface of the interface member 8, a bracket 11 movable up and down along a vertical straight guide 10 supported on the structural member 9, a z-motor 13 for driving the bracket 11 in up-and-down direction via a ball screw 12 mounted on the bracket 11, a pick-up nozzle 15 attached at the lower end of a vertical shaft 14 mounted on the bracket 11, a θ-motor 16 mounted on the bracket 11 for controlling the angular position of the nozzle 15 by rotating the shaft 14 about its axis, a position detector 18 mounted on the structural member 9 for detecting the position of an electronic component picked-up by the nozzle 15, and a camera 19 mounted on the structural member 9 for recognising marks on the circuit board 5, pick-up position on the component 17 at the time of picking up the component and the position of the component 17 mounted on the board 5.

By equalising the distance between the pick-up nozzles on the pick-up units 7 with the distance between the top ends of the feeders 3, a plurality of pick-up units 7 can pick-up a plurality of components at the same time, and the same number of picked-up components as the number of nozzles can be placed on the board 5 simultaneously at each XY movement by the XY robot 6, hence the mounting time can be shortened.

In Japanese laid-open patent publication No. Hei 9-307286, which corresponds to EP0808091 A1, a component mounting machine having a X guide rail on which two head units are mounted movable independently of each other is disclosed, where the components picked-up by both heads are placed onto respective predetermined positions on two boards independently positioned with respect to each other.

WO 95/19099 discloses a surface mount machine having one or more component pick-up devices movable independently in a first direction and two wagons movable independently in a second direction perpendicular to the first direction, for carrying printed circuit boards between a conveyor position and a mounting position adjacent the pick-up devices.

As described above, as the number of pick-up units 7 increases with respect to the XY robot 6, the cycle time of picking up and mounting the components is reduced to improve productivity, theoretically.

However, even if the number of pick-up units 7 increases, the productivity cannot be improved in proportion to the increase of the number. On the contrary, the productivity might be reduced relatively to the increase of the number of units.

In addition, since the increase of the number of pick-up units means the increase of transportation mass for the XY robot 6, it may become difficult to maintain the moving speed and acceleration of the units, which sometimes results in longer cycle time of picking-up and mounting the components.

For solving the above problems, there is such an apparatus that a head unit is moved only in X direction (transporting direction of the board) and the board is moved in Y direction perpendicularly. Another case is to provide two beams in X direction, being mounted respective head units thereon.

However, in the former case, the apparatus occupies large installation area and has difficulty to attain high speed operation. In the latter one, component storage sections have to be provided in front and rear sides of the apparatus, which means complicated structure, higher cost for production line, and higher cost of apparatus.

In the machine disclosed in the Japanese laid-open patent publication Hei 9-307286, when placing the components by two head units, after placing the component of one side, the X rail having two heads has to be moved in Y direction, and then the other side component is placed onto the other side board. Therefore, it takes longer mounting cycle time.

It is therefore an object of the present invention to provide an electronic component mounting machine and method therefor for mounting electronic components in high speed without increasing installation area of the machine and its cost with a simple structure.

The above object can be achieved by a machine cited in claim 1 appended hereto. According to a first aspect of the present invention, a machine for mounting electronic components is provided in which a Y-motor drives one of the board positioning areas in the Y-direction relative to the other board positioning area so as to correct a Y direction deviation between a component to be mounted on a board placed on said one of the board positioning areas and a component to be mounted on a board placed on the other board positioning area.

The above object of the invention can be achieved by a method cited in claim 2 appended hereto. According to a second aspect of the present invention, a method for mounting components in the machine for mounting electronic components is provided, in which said other board positioning area with movement in the Y direction is positioned relative to said one of the board positioning areas to correct a Y-direction deviation between a component to be mounted on a board on said one of the board positioning areas and a component to be mounted on a board placed on the other board positioning area so as to position the other transport unit above a predetermined Y coordinate position of the board, and the picked up components are placed onto the two boards substantially simultaneously.

In this invention, the head unit has two transport units supported slidably on one X-guide, and at least one of the board positioning areas can be moved and positioned in Y direction relative to other board positioning area. Therefore, when the components are mounted on the boards simultaneously, the displacement of both X and Y directions between the plural boards can be easily corrected. Consequently, electronic components can be mounted on the boards in high speed.

Since the transport units are supported on one same guide, the machine can be simplified and be of a smaller size.

Embodiments of the invention will be described hereunder, purely by way of example, with reference to the accompanying drawings.

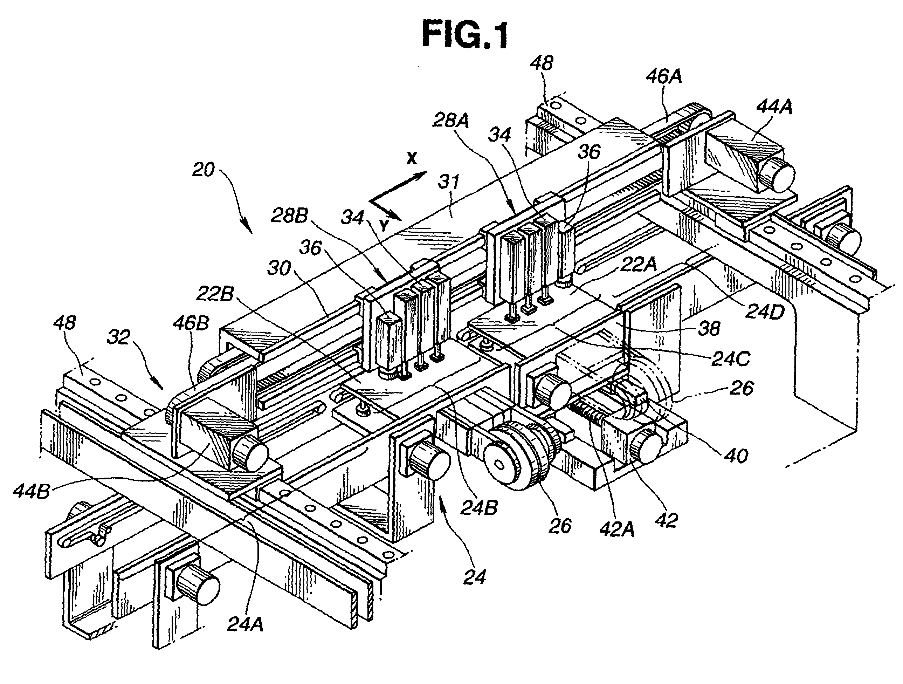

A perspective view of a component mounting machine 20 embodying the invention is shown in Fig. 1. The machine 20 comprises a board conveyor section 24 for transporting and stopping boards 22A,22B in one direction (X direction), an electronic component storage section 26 disposed along the board conveyor section 24 for supplying electronic components sequentially, a pair of transport units 28A,28B for receiving respective components from the component storage section 26 and mounting them onto the boards 22, and an XY robot 32 having an X-guide 30 for supporting the transport units 28A,28B which are slidably movable in X direction in parallel with the transport direction of the boards 22, and driving the X-guide 30 in the direction Y perpendicular thereto.

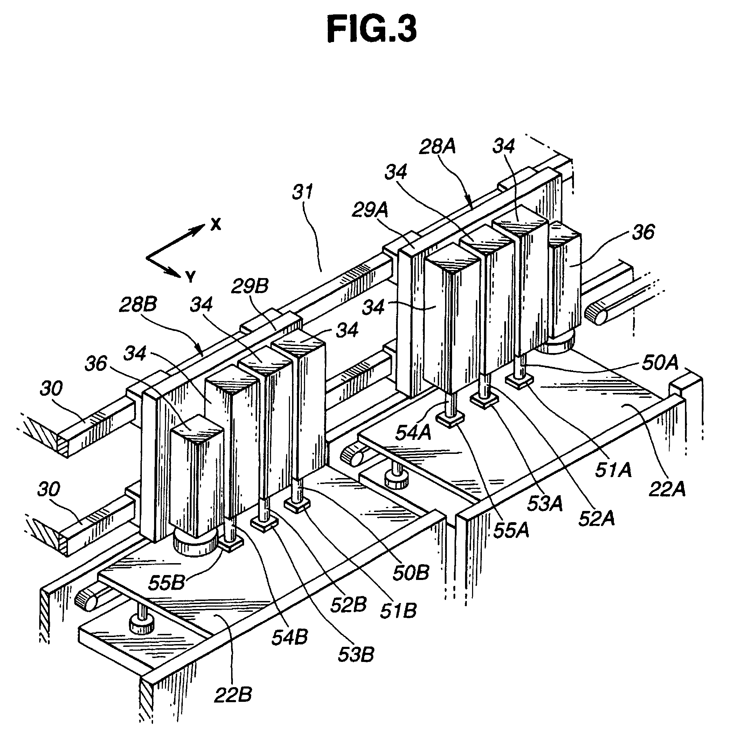

Each of the transport units 28A,28B have three pick-up units 34 similar to Fig. 11, and a camera 36 (position detectors are not shown). The transport units 28A,28B are supported on the X-guide 30 via mounting plates 29A, 29B working as mechanical interface members (see Fig.3).

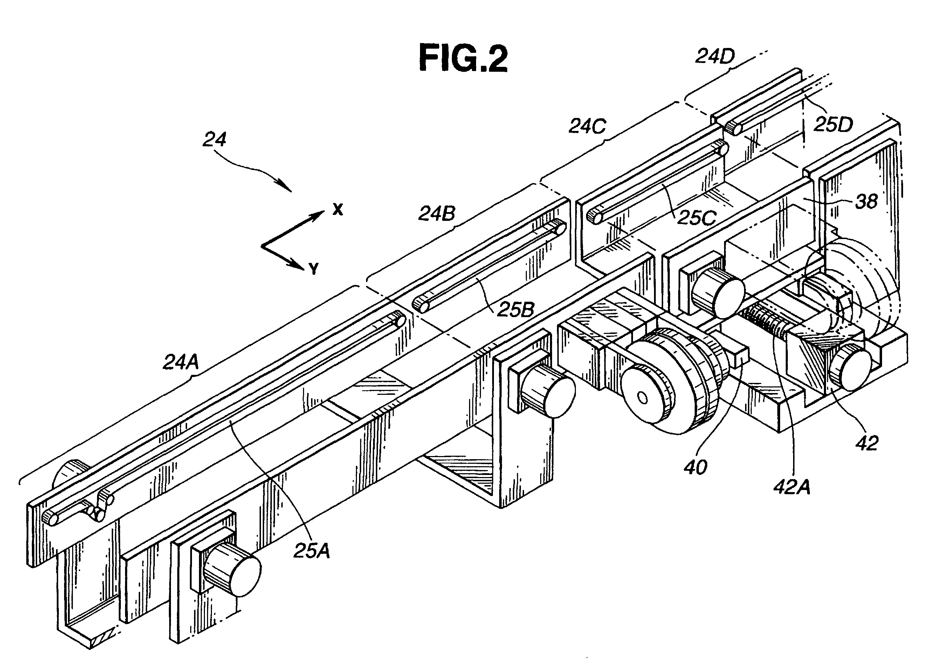

Fig.2 shows an enlarged perspective view of the board conveyer section 24, which has, sequentially in board transporting direction, a board carry-in area 24A, a second positioning area 24B, a first positioning area 24C, a board carry-out area 24D, and conveyers 25A through 25 D, each of which can independently transport and stop the boards 22.

The boards 22A, 22B are positioned at the first and second positioning areas 24C, 24B, respectively, so that the respective components can be placed on the boards by two transport units 28A, 28B.

As shown in Figs.1 and 2, the first positioning area 24C has a U-shaped frame 38, which supports the conveyer 25C and are supported movable horizontally in Y direction along a Y-direction straight guide 40 through a ball screw 42A driven by a Y-motor 42.

Reference numerals 44A,44B in Fig.1 designate transport motors for driving the transport units 28A,28B, via belts 46A,46b, respectively, along the X-guide 30.

Both ends of a X-direction beam 31 together with the motors 44A, 44B are supported on a Y-direction guide 48 of the XY robot 32, and are slidably movable in Y direction driven by a motor (not shown).

The component pick-up units 34 on the transport units 28A,28B have respective pick-up nozzles 50A,52A,54A and 50B,52B,54B (see Fig.3), which angular positions are controlled by the rotation of their respective shafts about their axes by respective motors similar to those in Fig.11.

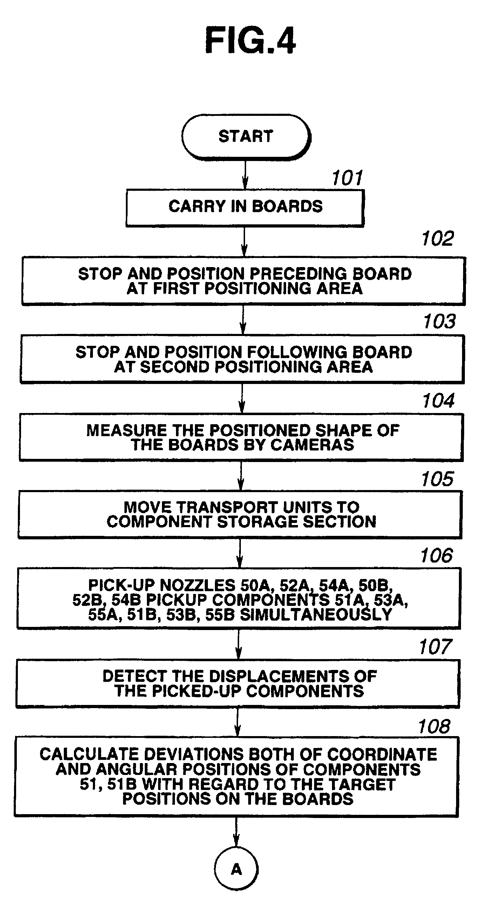

The process of mounting components on the boards 22A,22B using the component mounting machine 20 will be explained in detail with reference to the drawings Fig.4 through Fig.9.

As shown in Fig.4, the process begins at step 101, where the boards 22A,22B are carried in the board conveyer section 24 from the board carry-in area 24A.

Then at step 102, the preceding board 22A is stopped and positioned at the first positioning area 24C, and the following board 22B is transported to the second positioning area 24B and positioned at step 103.

At this time, the camera 36 captures the positioned shape of the boards 22A,22B and are measured their positions at step 104.

Then at step 105, the XY robot 32 moves the transport units 28A,28B to the pick-up position of the components at the component storage section 26.

At step 106,the pick-up nozzles 50A,52A,54A and 50B,52B,54B pick up respective components 51A,53A,55A and 51B,53B,55B simultaneously.

Because the picked-up components are usually more or less shifted and/or tilted with regard to their nozzle centers, these displacements must be corrected. As to the nozzle disposition, nozzles 50A and 50B, 52A and 52B, and 54A and 54B are aligned in the same Y coordinate positions, respectively.

Before the correction, at step 107, both coordinate position and angular orientation of each component are detected by the position detector. Then at steps 108 through 112, the deviation in X,Y direction and tilting angle are calculated and corrected so that the components 51A,51B can be simultaneously mounted on the boards 22A, 22B by the nozzles 50A, 50B respectively.

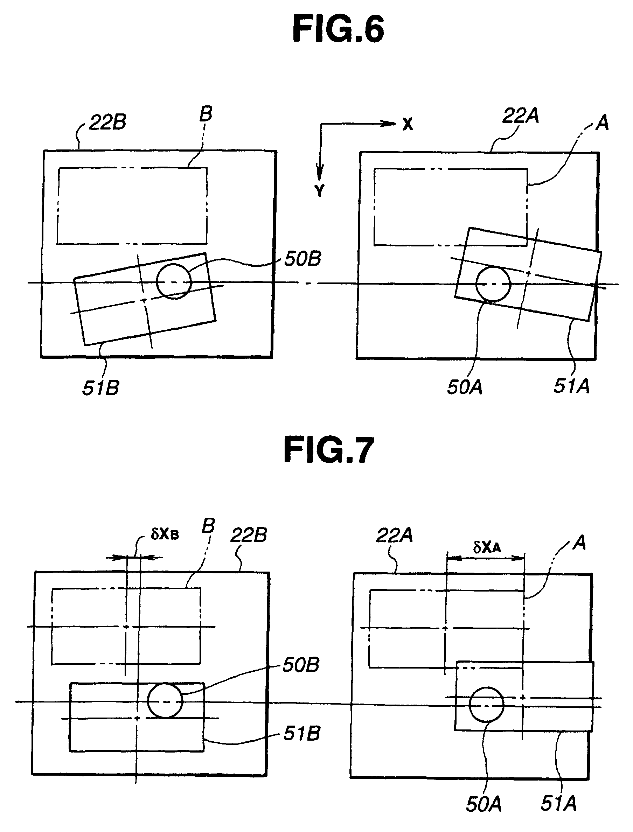

In more detail, first at step 108, the deviation in X,Y direction and angular orientation of each of the components 51A 51B with regard to target positions (positions A,B in Figs.6-9) are calculated, based on the distance between the target positions on the boards 22A,22B for the components 51A,51B, and the picked-up shape of the components 51A,51B detected by the position detectors.

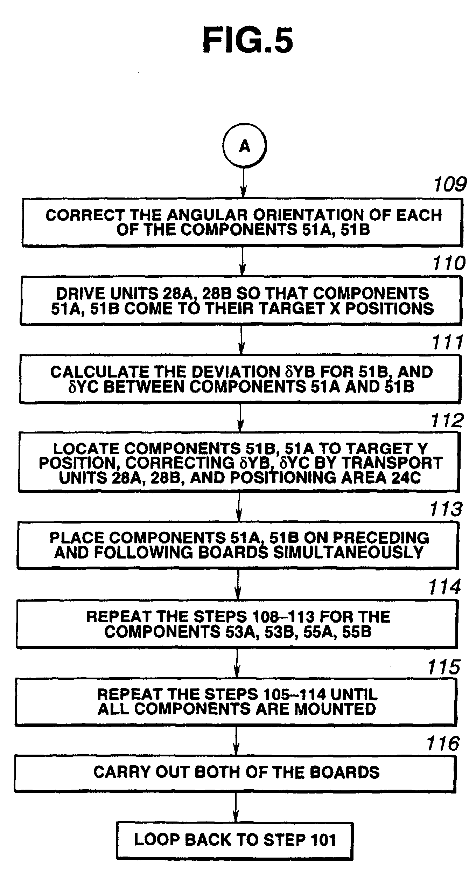

Then at step 109 (refer to Fig.5 hereunder),the nozzles 50A,50B are rotated to correct the tilted angles of the components 51A,51B to the predetermined orientations (see Fig.7).

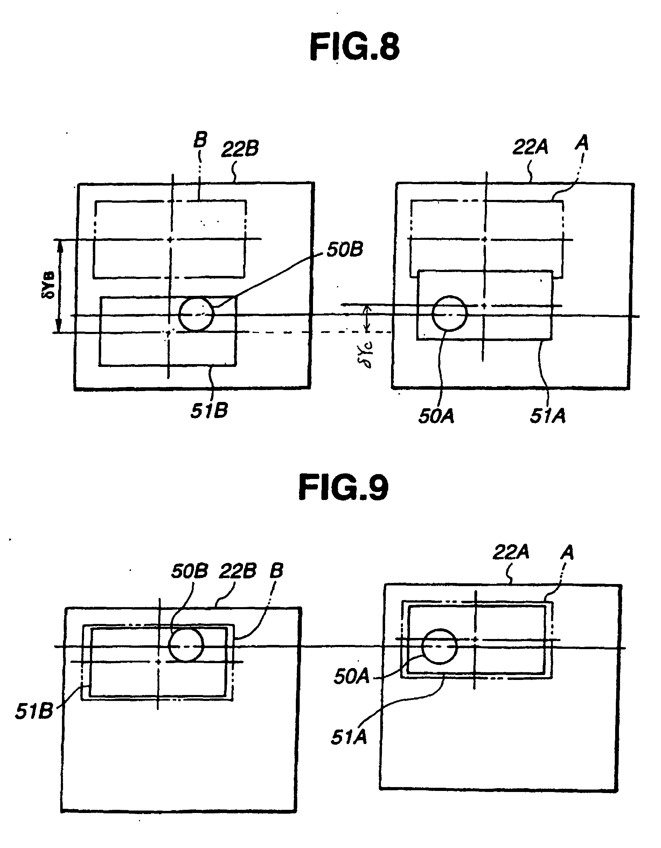

At step 110, the XY robot 32 drives and positions the transport units 28A,28B in X direction through the mechanical interface members, plates 29A,29B so that the deviations in X direction δXA,δXB between the picked-up components 51A,51B and the respective target positions on the boards 22A,22B can be corrected (see Fig.8).

At step 111, it is calculated the deviation δYB between the component 51B and the predetermined Y coordinate position, and the Y direction deviation δYC between the picked-up components 51A and 51B.Then at step 112, the transport units 28A,28B are moved in Y direction by δYB by the robot 32 to coincide the component 51B with the target position B in Y direction. At the same time, the first positioning area 24C with the board 22A including the frame 38 is moved in Y direction by δYC by the Y-motor 42 to coincide the component 51A with the target position A in Y direction (see Fig.9).

After the positional correction, the components 51A,51B are placed on the respective boards 22A,22B simultaneously by the respective pick-up nozzles 50A,50B at step 113.

At step 114, the steps 108 through 113 explained before are repeated for mounting the components 53A,53B and 55A,55B.

Further, at step 115, the steps 105 through 114 are repeated until all components to be placed are mounted on the boards.

After mounting all components to be placed on the boards, the boards 22A and 22B are carried out through the board carry-out area 24D at step 116, and the process can loop back to the step 101.

While two transport units are provided in the described embodiment, the invention is not limited to this case, but more than three units can be provided. The number of component pick-up units on each of the transport units is not also to be limited to three units, but can be at least one unit.

As to the board conveyor section in the embodiment, the number of positioning areas is the same as those of the transport units, but these numbers can differ to each other. It is adaptable if the position areas are arranged movably in Y direction relative to a plurality of transport units. Therefore, such structures can be employed that all transport units are movable by means of ball screws of the like, or only one transport unit is fixed with other units being movable in Y direction.

In the embodiment described above, the components are sequentially mounted on the two boards 22A,22B simultaneously, but the invention is not limited to the embodiment. It is possible in such a manner, for example, that each of the transport units 22A,22B mounts the components covering half zone of the preceding and following boards in board travelling direction. In other words, the transport unit 28A could mount components onto the front half zones of the boards 22A,22B, and the unit 22B onto the rear half zones of the boards 22A,22B.

The XY robot 32 is driven by motors, but these motors could include linear motors.

As explained above, the present invention provides a component mounting machine in which a plurality of electronic components can be mounted onto two boards simultaneously with a simple structure in high speed.

Fig.1 is a perspective view of a component mounting machine embodying the invention.

Fig.2 is an enlarged perspective view showing a board conveyer section.

Fig.3 is a perspective view illustrating the relationship between a head unit and circuit boards.

Fig.4 is a flow chart showing the former half of the component mounting process in the component mounting machine.

Fig.5 is a flow chart showing the latter half of the component mounting process in the component mounting machine.

Fig.6 is a plane view showing the positional relationship between the boards and the components to be mounted at the time of picking up components in mounting process.

Fig.7 is a plan view showing the positional relationship between the boards and the components after correction of the angular orientation of each component in mounting process.

Fig.8 is a plan view showing the positional relationship between the boards and the components after correction of X direction coordinate of each component in mounting process.

Fig.9 is a plan view showing the positional relationship between the boards and the components after corrections both of angular and coordinate positions of each component in mounting process.

Fig.10 is a schematic perspective view showing a conventional component mounting machine.

Fig.11 is an enlarged perspective view showing a head unit of the conventional component mounting machine.

### [Explanation of the reference numerals]

20 - electronic component mounting machine, 22 - circuit board, 24 - board conveyer system, 24A - board carry-in area, 24B - second positioning area, 24C - first positioning area, 24D - board carry-out area, 26 - electronic component storage section, 28A,28B - transport unit, 30 - X-guide, 32 - XY robot, 34 - component pick-up unit, 36 - camera, 40 - straight guide, 42 - Y-motor

## Claims

1. A machine for mounting electronic components (20) comprising:
a board conveyor section (24) for conveying circuit boards (22A, 22B) in a transporting direction through a board carry-in area (24A), two board positioning areas (24B, 24C) and a board carry-out area (24D) in this order and stopping them in the board positioning areas (24B, 24C);
an electronic component storage section (26) disposed along the board conveyor section (24) for supplying the electronic components (51A, 53A, 55A, 51B, 53B, 55B) sequentially;
a head unit having a plurality of component pick-up units (34), each pick-up unit (34) having a pick-up nozzle (50A, 52A, 54A, 50B, 52B, 54B), for receiving one of the components (51A, 53A, 55A, 51B, 53B, 55B) from the component storage section (26) and placing it onto a board (22A, 22B) positioned at a positioning area (24B, 24C), and each pick-up unit (34) including an angular positioning device for the nozzle; and
an XY robot (32) for supporting and moving the head unit in an X direction parallel to the transporting direction of the boards (22A, 22B) and in a Y direction perpendicular thereto;
wherein the head unit has two transport units (28A, 28B) supported slidably on one X-guide (30), each transport unit (28A, 28B) being movable independently to the other in the X direction and having at least one component pick-up unit (34), and
**characterized in that** a Y-motor is arranged to drive one of the board positioning areas (24C) in the Y direction relative to the other board positioning area (24B) so as to correct a Y-direction deviation (δYC) between a component (51A) to be mounted on a board (22A) placed on said one of the board positioning areas (24C) and a component (51B) to be mounted on a board (22B) placed on the other board positioning area (24B).

2. A method for mounting components in an electronic component mounting machine (20), comprising the steps of:
conveying circuit boards (22B,22A) through a board carry-in area (24A), two board positioning areas (24B,24C), and a board carry-out area (24D) in this order and stopping them in the board positioning area (24B, 24C);
picking up components (51A,53A,55A; 51B,53B,55B) from a component storage section (26) with pick-up nozzles (50A,52A,54A; 50B,52B,54B);
altering the angular orientation of each picked up component (51A,53A,55A; 51B,53B,55B) by an angular positioning device of a pick-up unit (34);
positioning two transport units (28A,28B) above predetermined X coordinate positions on the boards (22A,22B) placed on respective board positioning areas (24B,24C) with independent movement in an X direction;
positioning by an XY robot (32), one of the transport units (28B) above a predetermined Y coordinate position on the board (22B) placed on one of the board positioning areas (24B);
**characterised by** positioning the other board positioning area (24C) with movement in the Y direction relative to said one of the board positioning areas (24B) to correct a Y-direction deviation (δYC) between a component (51B) to be mounted on a board (22B) placed on said one of the board positioning areas (24B) and a component (51A) to be mounted on a board (22A) placed on the other board positioning area (24C) so as to position said other transport unit (28A) above a predetermined Y coordinate position on the board (22A); and
placing the picked up components (51A,53A,55A; 51B,53B,55B) onto the two boards (22A,22B) substantially simultaneously.

## Patentansprüche

1. Maschine zum Anbringen von elektronischen Komponenten (20), umfassend:
einen Platinenbefördererabschnitt (24) zum Befördern von Schaltungsplatinen (22A, 22B) in einer Transportrichtung durch ein Platinenhereinführungsgebiet (24A), zwei Platinenpositionierungsgebiete (24B, 24C) und ein Platinenherausführungsgebiet (24D) in dieser Reihenfolge und Stoppen von diesen an den Platinenpositionierungsgebieten (24B, 24C);
einen Speicherabschnitt (26) für elektronische Komponenten, der entlang des Platinenbefördererabschnitts (24) angeordnet ist, zum Zuführen der elektronischen Komponenten (51A, 53A, 55A, 51B, 53B, 55B) sequenziell;
eine Kopfeinheit mit einer Vielzahl von Komponentenaufnahmeeinheiten (34), wobei jede Aufnahmeeinheit (34) eine Aufnahmedüse (50A, 52A, 54A, 50B, 52B, 54B) aufweist, zum Empfangen von einer der Komponenten (51A, 53A, 55A, 51B, 53B, 55B) von dem Komponentenspeicherabschnitt (26) und zum Platzieren davon auf einer Platine (22A, 22B), die an einem Positionierungsgebiet (24B, 24C) positioniert ist, und wobei jede Aufnahmeeinheit (34) eine Winkelpositionierungseinrichtung für die Düse einschließt; und
ein XY-Roboter (32) zum Haltern und Bewegen der Kopfeinheit in einer X-Richtung parallel zu der Transportrichtung der Platinen (22A, 22B) und in einer Y-Richtung senkrecht dazu;
wobei die Kopfeinheit zwei Transporteinheiten (28A, 28B) aufweist, die gleitbar auf einer X-Führung (30) gehaltert werden, wobei jede Transporteinheit (28A, 28B) unabhängig zueinander in der X-Richtung bewegbar ist und wenigstens eine Komponentenaufnahmeeinheit (34) aufweist, und **dadurch gekennzeichnet, dass** ein Y-Motor angeordnet ist, um ein Gebiet der Platinenpositionierungsgebiete (24C) in der Y-Richtung relativ zu dem anderen Platinenpositionierungsgebiet (24B) anzutreiben, um so eine Y-Richtungsabweichung (δXC) zwischen einer Komponente (51A), die auf einer Platine (22A) angebracht werden soll, die auf dem einen Gebiet der Platinenpositionierungsgebiete (24C) angebracht ist, und einer Komponente (51B), die auf einer Platine (22B) angebracht werden soll, die auf dem anderen Platinenpositionierungsgebiet (24B) platziert ist, zu korrigieren.

2. Verfahren zum Anbringen von Komponenten in einer Anbringungsmaschine (20) für elektronische Komponenten, umfassend die folgenden Schritte:
Befördern von Schaltungsplatinen (22A, 22B) durch ein Platinenhereinführungsgebiet (24A), zwei Platinenpositionierungsgebiete (24B, 24C), und ein Platinenherausführungsgebiet (24D) in dieser Reihenfolge und zum Stoppen von diesen an dem Platinenpositionierungsgebiet (24B, 24C);
Aufnehmen von Komponenten (51A, 53A, 55A; 51B, 53B, 55B) von einem Komponentenspeicherabschnitt (26) mit Aufnahmedüsen (50A, 52A, 54A; 50B, 52B, 54B);
Ändern der Winkelorientierung von jeder aufgenommenen Komponente (51A, 53A, 55A; 51B, 53B, 55B) durch eine Winkelpositionierungseinrichtung einer Aufnahmeeinheit (34);
Positionieren von zwei Transporteinheiten (28A, 28B) über vorgegebenen X-Koordinatenpositionen auf den Platinen (22A, 22B), die auf jeweiligen Platinenpositionierungsgebieten (24B, 24C) platziert sind, mit einer unabhängigen Bewegung in einer X-Richtung;
Positionieren von einer der Transporteinheiten (28B) über einer vorgegebenen Y-Koordinatenposition auf der Platine (22B), die auf einem Gebiet der Platinenpositionierungsgebiete (24B) platziert ist, durch einen XY-Roboter (32);
**gekennzeichnet durch** ein Positionieren des anderen Platinenpositionierungsgebietes (24C) mit einer Bewegung in der Y-Richtung relativ zu dem einen Gebiet der Platinenpositionierungsgebiete (24B), um eine Y-Richtungsabweichung (δYC) zwischen einer Komponente (51B), die auf einer Platine (22B) angebracht werden soll, die auf dem einen Gebiet der Platinenpositionierungsgebiete (24B) platziert ist, und einer Komponente (51A), die auf einer Platine (22A) angebracht werden soll, die auf dem anderen Platinenpositionierungsgebiet (24C) platziert ist, zu korrigieren, um die andere Transporteinheit (28A) über einer vorgegebenen Y-Koordinatenposition auf der Platine (22A) zu positionieren; und
Platzieren der aufgenommenen Komponenten (51A, 53A, 55A; 51B, 53B, 55B) auf den zwei Platinen (22A, 22B) im Wesentlichen gleichzeitig.

## Revendications

1. Machine de montage de composants électroniques (20), comprenant:
une section de transport de cartes (24) pour transporter successivement des cartes de circuit imprimé (22A, 22B) dans une direction de transport à travers une zone d'entrée des cartes (24A), deux zones de positionnement des cartes (24B, 24C) et une zone de sortie des cartes (24D) dans cet ordre et pour les arrêter dans les zones de positionnement des cartes (24B, 24C);
une section de stockage des composants électroniques (26) agencée le long de la section de transport des cartes (24) pour assurer une alimentation séquentielle des composants électroniques (51A, 53A, 55A, 51B, 53B, 55B);
une unité de tête comportant plusieurs unités de prélèvement des composants (34), chaque unité de prélèvement (34) comportant une buse de prélèvement (50A, 52A, 54A, 50B, 52B, 54B) pour recevoir un des composants (51A, 53A, 55A, 51B, 53B, 55B) de la section de stockage des composants (26) et le placer sur une carte (22A, 22B) positionnée au niveau d'une zone de positionnement (24B, 24C), chaque unité de prélèvement (34) englobant un dispositif de positionnement angulaire de la buse; et
un robot XY (32) destiné à supporter et à déplacer l'unité de tête dans une direction X parallèle à la direction de transport des cartes (22A, 22B) et dans une direction Y perpendiculaire à celle-ci;
l'unité de tête comportant deux unités de transport (28A, 28B) supportées par glissement sur un guide X (30), chaque unité de transport (28A, 28B) pouvant être déplacée indépendamment dans la direction X et comportant au moins une unité de prélèvement des composants (34), **caractérisée en ce qu'**un moteur Y sert à entraîner une des zones de positionnement des cartes (24B) dans la direction Y par rapport à l'autre zone de positionnement des cartes (24B) de sorte à corriger une déviation dans la direction Y (δYC) entre un composant (51A) devant être monté sur une carte (22A) placée sur ladite une des zones de positionnement des cartes (24C) et un composant (51B) devant être monté sur une carte (22B) placée sur l'autre zone de positionnement des cartes (24B).

2. Procédé de montage de composants dans une machine de montage de composants électroniques (20), comprenant les étapes ci-dessous:
transport successif des cartes de circuit imprimé (22B, 22A) à travers une zone d'entrée des cartes (24A), deux zones de positionnement des cartes (24B, 24C) et une zone de sortie des cartes (24D) dans cet ordre et pour les arrêter dans la zone de positionnement des cartes (24B, 24C);
prélèvement des composants (51A, 53A, 55A ; 51B, 53B, 55B) d'une section de stockage des composants (26) par des buses de prélèvement (50A, 52A, 54A ; 50B, 52B, 54B);
changement de l'orientation angulaire de chaque composant prélevé (51A, 53A, 55A; 51B, 53B, 55B) par un dispositif de positionnement angulaire d'une unité de prélèvement (34);
positionnement de deux unités de transport (28A, 28B) au-dessus de positions de coordonnées X prédéterminées sur les cartes (22A, 22B) placées sur les zones de positionnement respectives des cartes (24B, 24C), avec un déplacement indépendant dans une direction X;
positionnement par l'intermédiaire d'un robot XY (32) de l'une des unités de transport (28B) au-dessus d'une position de coordonnée Y prédéterminée sur la carte (22B) placée sur une des zones de positionnement des cartes (24B);
**caractérisé par** l'étape de positionnement de l'autre zone de positionnement des cartes (24C) par un déplacement dans la direction Y par rapport à ladite une des zones de positionnement des cartes (24B) pour corriger une déviation dans la direction Y (δYC) entre un composant (51B) devant être monté sur une carte (22B) placée sur ladite une des zones de positionnement des cartes (24B) et un composant (51A) devant être monté sur une carte (22A); placée sur l'autre zone de positionnement des cartes (24C), de sorte à positionner ladite autre unité de transport (28A) au-dessus d'une position de coordonnée Y prédéterminée sur la carte (22A); et
agencement des composants prélevés (51A, 53A, 55A ; 51B, 53B, 55B) sur les deux cartes (22A, 22B), de manière pratiquement simultanée.
